# EUROPEAN PATENT SPECIFICATION

(11) **EP 2 378 565 B1**
(45) Date of publication and mention of the grant of the patent: **06.03.2013**
(21) Application number: 11161942.5
(22) Date of filing: 11.04.2011
(51) Int. Cl.: H01L 31/045, H01L 31/048, F24J 2/36, F24J 2/52

(54) **Deployable solar panel system**
Einsetzbares Sonnekollektorsystem
Système de panneau solaire déployable

(30) Priority: 16.04.2010 US 761972
(43) Date of publication of application: 19.10.2011
(73) Proprietor: General Electric Company, Schenectady, NY 12345 (US)
(72) Inventor: Korman, Charles Steven, Niskayuna, NY 12309 (US); Johnson, Neil Anthony, Niskayuna, NY 12309 (US)
(74) Representative: Illingworth-Law, William Illingworth

(56) References cited:
- WO-A2-2005/108877
- DE-A1- 10 047 400
- FR-A1- 2 525 393

## Description

### BACKGROUND OF THE INVENTION

### Field of the Invention

The invention relates to the installation of solar cell panels, and in particular to a system and method of installing solar cell panels on a low slope surface, such as a rooftop of a commercial building, and the like.

### Description of the Related Art

Currently, there is approximately 11 billion square meters of commercial rooftop surface available worldwide. Tapping even a small fraction of this potential would make a significant impact on the world's energy needs.

On roofs of commercial buildings, which usually have no or low slope, modules are mounted at a desired tilt angle using a dedicated substructure, which adds additional weight to the roof. Mounting a solar array on existing residential buildings does not normally pose a problem with additional weight because the typical residential substructure is built for heavy snow and is capable of supporting the framed solar modules and mounting structure. However, when working on commercial buildings, it is absolutely important that the addition of more weight on the roof be carefully evaluated, especially when it comes to old an/or light-framed, or wood agricultural buildings. In addition, many residential and commercial buildings, particularly in the western, and southern parts of the United States, are not designed to handle snow loading and are structurally weaker. Many warehouses and large box stores are not equipped to handle heavy solar systems.

These additional weight loads can be substantial. For example, a method for mounting framed modules on a commercial roof is through the use of plastic troughs, which are filled with gravel or equivalent to secure the array to the roof. This technique can be used so as to avoid damaging the roof by drilled holes to fix a mounting structure. With such systems, additional weight of up to 300 kg/m² can be reached, which needs to be supported by the existing roof structure.

In addition, additional wind loads emerge almost always when additional components are mounted onto a roof. Even if solar modules are mounted in parallel to the roof, the edges are exposed to wind and remarkable loads may be introduced into the roof structure. The impact on the static of the building is most obvious looking at elevated mounted PV systems on flat roofs of commercial buildings. Due to the elevation of the PV modules, they operate like sails and catch the wind. The occurring stress introduced into the building structure depends on the height of the building and the average local wind speed and is determined according to building codes and standards, following to which the building needs to be statically analyzed.

To meet rooftop wind loading requirements, conventional flat solar panels typically must be secured to the roof or building structure with either expensive, heavy mounting hardware or ballast that is difficult to install and remove, if necessary, for roof repair, and the like. There have been some attempts to eliminate the heavy mounting hardware by simply applying adhesives to the solar panels and then mount them to the roof.

Further, a heavy ballasted PV system can damage a membrane roof as the system drags across or compresses the roof. Together with the need for tilting, the resulting mounting systems require a substantial investment in labor, hardware, design and other balance of system costs.

WO-A-2005/108877 concerns a transportable system for producing solar electricity, comprising a plurality of solar cell modules mounted in a hinged arrangement, so that the modules can be deployed and folded away for easy transport thereof. FR-A-2 525 393 also concerns foldable solar cell panels connected by hinges, and DE-A-100 47 400 concerns a solar device with a frame for hinged mounting of solar modules in a roof-like configuration.

### BRIEF SUMMARY OF THE INVENTION

According to a first aspect, the present invention provides a deployable solar panel system as defined in appended claim 1.

According to a second aspect, the present invention provides a method for installing a deployable solar cell system as defined in appended claim 5.

The inventors have recognized that a lightweight, flexible PV module that does not require an expensive racking system will result in the lowest installed cost, particularly for a low slope commercial rooftop.

The inventors have also recognized that PV modules that are installed on a low slope roof at a tilt angle of about 2-5 degrees and do not self-shade provide the highest per area power yield.

In accordance with the invention, the costs and complexity associated with installing conventional solar cell panels is reduced by a solar cell system that includes a plurality of solar cell panels that are mechanically and electrically coupled to each other prior to shipment, while capable of being folded in a stacking arrangement within a packaging container during shipment, and unfolded and deployed at a desired tilt angle during installation at the installation site without the need for a conventional heavy mounting system.

### BRIEF DESCRIPTION OF THE DRAWINGS

FIG. 1 is a schematic perspective view of a set of sliver solar cells retained within a wafer frame, a quarter of which has been removed in order to view half of the slivers;
FIG. 2 is a top plan view of a portion of a solar cell panel including a modular tabbed subassembly on a flexible backsheet;
FIG. 3 is cross-sectional side view of the solar cell panel of FIG. 2;
FIG. 4 is a perspective view of a deployable solar panel system according to an embodiment of the invention;
FIGS. 5(a)-5(d) are enlarged perspective views of a method of mounting the deployable solar panel system to a structure, such as a roof, according to an embodiment of the invention;
FIG. 6 is an enlarged perspective view of a method of mounting the deployable solar panel system is mounted to the roof according to an alternative embodiment of the invention;
FIG. 7 is a perspective view of the deployable solar panel system of FIG. 4 with each solar cell panel having a DC-DC converter connected to a series string to electrically couple each of the solar cell panels together prior to shipment according to an embodiment of the invention;
FIG. 8 is a perspective view of the deployable solar panel system of FIG. 4 with a single DC-DC converter and a solar grid interconnection interface (combiner strip) to electrically couple each of the solar cell panels prior to shipment according to an alternate embodiment of the invention;
FIG. 9 illustrates the installation of the deployable solar panel system according to a method of the invention; and
FIG. 10 is a perspective view of the deployable solar panel system of the invention installed on a low slope commercial roof.

### DETAILED DESCRIPTION OF THE INVENTION

While the principles of the invention can be applied to different semiconductor based PV modules, the description that follows applies to one unique type of PV module that is based on a very thin elongate solar cell that is also bi-facial and results in a semi-flexible-to-flexible module assembly.

There are known processes that can produce elongate solar cells. As used herein, the term "elongate solar cell" refers to a solar cell of generally parallelepiped form and having a high aspect ratio in that its length is substantially greater (typically some tens to hundreds of times larger) than its width. The thickness of an elongate solar cell is largely immaterial to the present invention, but is typically four to one hundred times smaller than the width of the cell. The length and width of a solar cell define the maximum available active surface area for power generation (the active "face" or "faces" of the solar cell), whereas the length and thickness of a solar cell define the optically inactive surfaces or "edges" of a cell. A typical elongate solar cell is 10-120 mm long, 0.5-5 mm wide, and 35-80 microns thick.

For example, International Patent Application Publication No. WO 02/45143 describes a process for producing a large number of thin (generally <150 microns) elongate silicon substrates from a single standard silicon wafer, where the number and dimensions of the resulting thin elongate substrates are such that the total useable surface area is greater than that of the original silicon wafer. This is achieved by using at least one of the new formed surfaces perpendicular to the original wafer surfaces as the active or useable surface of each elongate substrate, and selecting the shorter dimensions in the wafer plane of both the resulting elongate substrates and the material removed between these substrates to be as small as practical.

Such elongate substrates are also referred to as "sliver substrates." The word "SLIVER" is a registered trademark of Origin Energy Solar Pty Ltd, Australian Registration No. 933476. WO 02/45143 also describes processes for forming solar cells on sliver substrates, referred to as "sliver solar cells." However, the word "sliver" generally refers to a sliver substrate, which may or may not incorporate one or more solar cells.

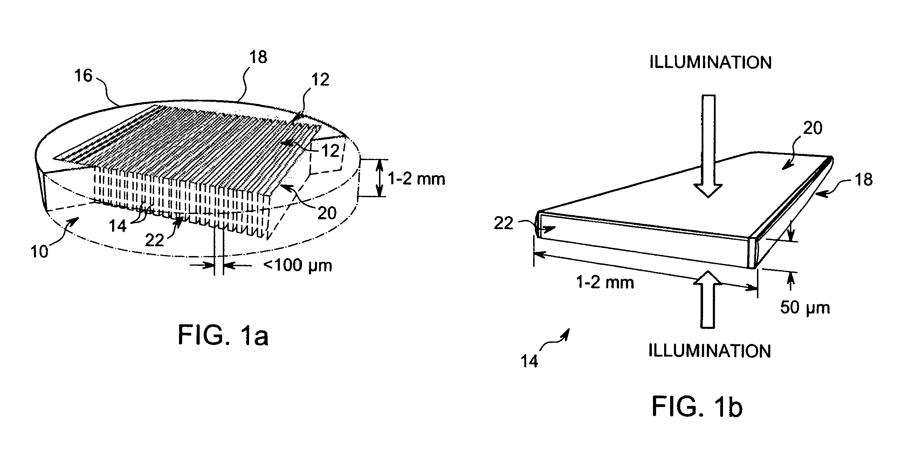

In general, elongate solar cells can be single-crystal solar cells formed on elongate substrates using essentially any solar cell manufacturing process. As shown in FIG. 1, elongate substrates are preferably formed in a batch process by machining (preferably by anisotropic wet chemical etching) a series of parallel elongate rectangular slots or openings 12 completely through a silicon wafer 10 to define a corresponding series of parallel elongate parallelepiped substrates or "slivers" 14 of silicon between the openings 12. The length of the slots 12 is less than, but similar to, the diameter of the wafer 10 so that the elongate substrates or slivers 14 remain joined together by the remaining peripheral portion 16 of the wafer, referred to as the wafer frame 16. Each sliver 14 is considered to have two edges 18 coplanar with the two wafer surfaces, two (newly formed) faces 20 perpendicular to the wafer surface, and two ends 22 attached to the wafer frame 16. As shown in FIG. 1, solar cells can be formed from the elongate substrates 14 while they remain retained by the wafer frame 16; the resulting elongate solar cells 14 can then be separated from each other and from the wafer frame to provide a set of individual elongate solar cells, typically with electrodes along their long edges. A large number of these elongate solar cells can be electrically interconnected and assembled together to form a solar power module.

When elongate substrates are formed in this way, the width of the elongate slots and the elongate silicon strips (slivers) in the plane of the wafer surface are both typically 0.05 mm, so that each sliver/slot pair effectively consumes a surface area of 1 x 0.1 mm from the wafer surface, where 1 is the length of the elongate substrate. However, because the thickness of the silicon wafer is typically 0.5-2 mm, the surface area of each of the two newly formed faces of the sliver (perpendicular to the wafer surface) is 1 x 0.5-2 mm, thus providing an increase in useable surface area by a factor of 5-20 relative to the original wafer surface (neglecting any useable surface area of the wafer frame).

A modular subassembly of elongated semiconductor strips or slivers can be assembled, which are preferably photovoltaic (PV) solar cells. Each subassembly may comprise any number of slivers dependent upon the voltage to be produced (e.g., 6, 35, 70, 300 or 3000 slivers). For example, a subassembly of 35 slivers 14 connected in series may produce a voltage (e.g., 0 V to 25 V) suitable to charge a 12 V battery.

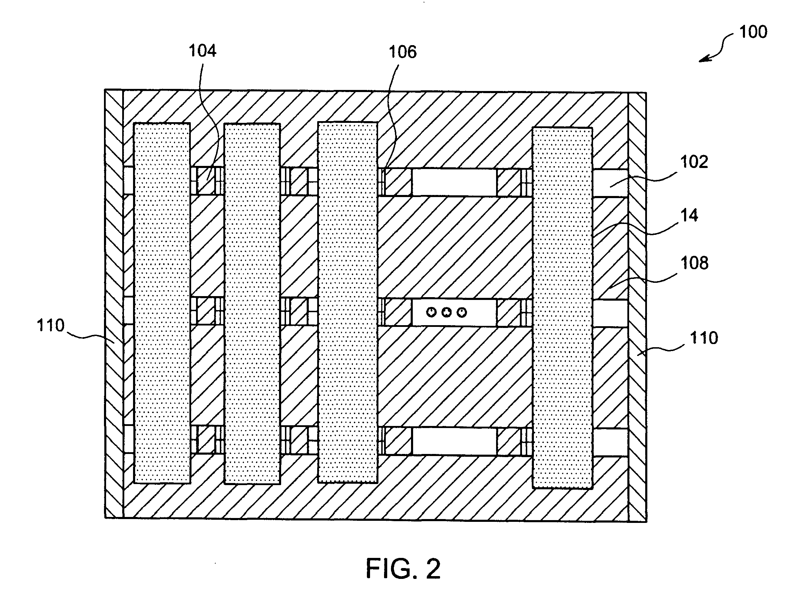

FIG. 2 provides an overview of a tabbed sliver subassembly 100 comprising a number of slivers 14 disposed in a parallel configuration on supporting media or "tracks" 120. For ease of illustration, FIG. 2 only depicts four slivers 14. The slivers 14 are affixed to three tracks 102. In this example, the tracks 102 are provided with conductive portions 104. The conductive portions 104 may, for example, be printed conductive epoxy containing silver, and the like. Other techniques and materials may be used to provide the conductive portions 104 between the slivers 14. Still further, the tracks 102 may be pre-printed with conductive portions or be pre-formed with the same, instead of having the conductive portion 104 applied after the slivers 14 are affixed to the tracks 102. The slivers 14 can be connected to the conductive portions 104 of the tracks 102 using conductive adhesive 106, such as solder, and the like. In addition, the modular subassembly 100 can be affixed to a backsheet 108 made of flexible material, such as plastic film of Tedlar-polyester (TP), Tedlar-Polyester-Tedlar (TPT), Tedlar-Aluminium-Tedlar (TAT), and the like. This may be done, for example, using a variety of adhesives or bonding media, such as optical adhesives, silicones, resins or laminating films such as EVA, PVB, and the like.

At the opposite terminal ends (lengthwise) of the subassemblies 100 are conductive tabs 110 for interconnecting subassemblies 100. The conductive tabs 110 may comprise strips of conductive metal such as copper (Cu), silver (Ag), copper and tin (Cu+Sn), gold (Au), or the like. Such tabs are well known to those skilled in the art. The tabs can be electrically connected to the sliver cells using the same method and materials that are used for connecting a sliver cell to another sliver cell (e.g., the tabs are another element in the parallel array). Other techniques, such as wire bonding, may be used. Similarly, the tabs may also be held by the supporting media, or may not.

The building of tabbed subassemblies allows the sliver subassemblies 100 to be used as a direct replacement for conventional solar cells. Stringing and lay-up machines may be used to interconnect the tabs of one subassembly to the tabs of a next subassembly (either in parallel or series; in a straight line or bent around corners etc) and create strings of subassemblies.

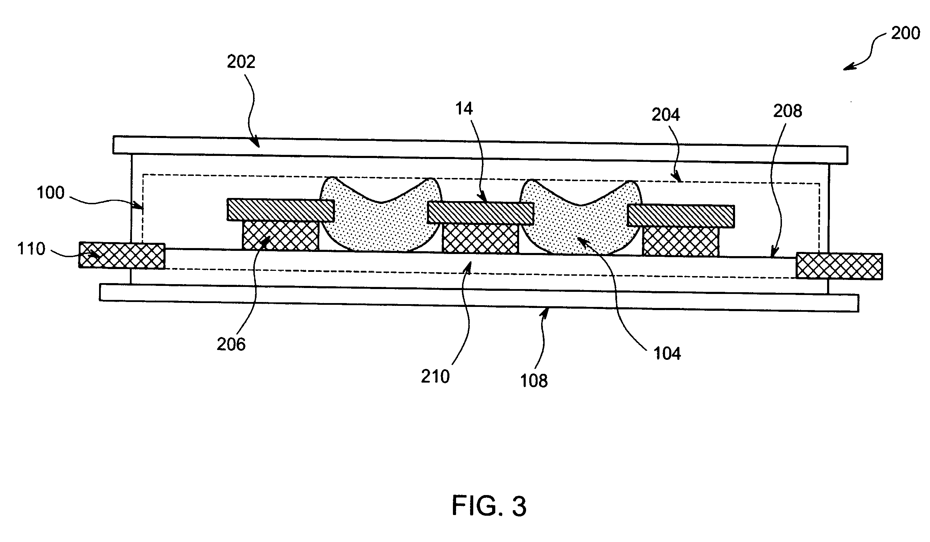

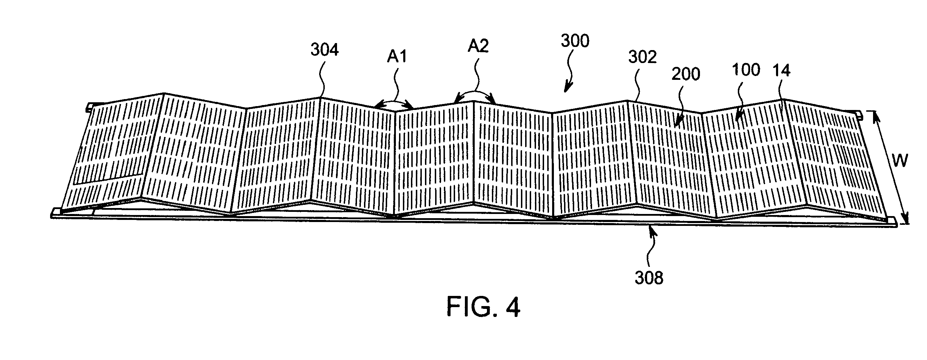

FIGS. 3 and 4 illustrate a fully assembled solar cell panel or PV module 200 that includes a plurality of banks of tabbed sliver subassemblies 100, each with a plurality of slivers 14 per subassembly. The solar cell panel 200 is built using Polyethylene Terephthalate (PET) in the specific embodiment shown, but other materials may be practiced.

As shown in FIGS. 3 and 4, the semiconductor-based solar cell panel or PV module 200 may be made using an optical cover sheet 202 made of TEFCEL® or other suitable optical material, an encapsulate 204 made of layer or layers of Ethylene Vinyl Acetate (EVA) adhesive or other suitable optical adhesive, a subassembly or a string of subassemblies 100 (the slivers 14, the conductive interconnection portions 104, the backsheet 108 and the tabs 110 are only shown in FIG. 4), an adhesive 206 for attaching each sliver 14 to a subassembly substrate 208 made of optical fiberglass or other suitable optical material, and a reflective material 210 disposed between the subassembly substrate 208 and the layer of backsheet 108. It will be appreciated that the invention is not limited by the specific structure of the solar cell panel 200, and that there are many alternatives to the above panel or module structure, including, but not limited to, the use of a glass front and rear, a glass rear and plastic film front, a film on the front and rear to make a flexible module, a rigid or semi-rigid plastic sheet instead of glass, and a metal or fiberglass layer on one side, and the like

The description above applies to one unique type of PV module 200 that is based on a very thin silicon solar cell that is also bi-facial and results in a semi-flexible-to-flexible module assembly. The PV module 200 is assumed to be of an optically transparent polymer/cell/polymer laminate construction based on an array of very thin silicon solar cells having a high aspect ratio of length to width (strips that thin and long) that are interconnected electrically in a series/parallel arrangement. These solar cells have a very small footprint relative to the module size and can be arranged into subarrays of high voltage series-connected cells (each cell is ∼ 0.5 volts so 300 cells connected in series would = 50 volts). A typical subarray might be 16 watts and 300 volts in comparison to a solar cell that produces 4 watts and has an open circuit voltage of 0.5 volts so that the total current is much less, and so are the I²R losses.

However, it will be appreciated that the invention is not limited to a specific semiconductor-based PV module described above, and that the principles of the invention described below can be applied to different semiconductor based PV modules. For example, the principles of the invention described below can be applied to a PV module based on thin film Copper Indium Gallium Diselenide (CIGS) solar devices that are formed onto a flexible substrate.

Referring now to FIGS. 4-6, a deployable solar panel system is shown generally at 300 according to an embodiment of the invention. The deployable solar panel system 300 includes a plurality of lightweight solar cell panels or PV modules 200 that are mechanically and electrically coupled to each other prior to shipment for easy installation at the installation site. Depending on the type of PV module 200, the edges of each solar panel or PV module 200 can be reinforced through the use of a frame member 302 made of metal, fiberglass, or other material that is used to strengthen or otherwise make rigid the PV module 200. For example, if the PV module is constructed using lightweight materials, such as the sliver cell subassembly 100 described above, then it may be desirable to provide the frame member 302 to add structural integrity to the PV module 200. On the other hand, the frame member 302 may not be necessary in cases where the PV module 200 is constructed with rigid materials, such as glass, and the like.

As mentioned earlier, each PV module 200 of the solar panel system 300 is mechanically coupled to each other prior to shipment to the installation site. Because the PV modules 200 are mechanically coupled to each other prior to shipment, installation costs are reduced as compared to conventional solar panel systems that need to be connected to each other at the installation site. There are many ways to mechanically couple each PV module 200 of the solar panel system 300.

One way to mechanically couple each PV module 200 of the solar panel system 300 is to affix a hinge assembly 301 comprising one or more hinge brackets 304 to the frame member 302 of the PV module 200. The hinge bracket(s) 304 can be affixed to the long edges of the frame member 302 using any suitable means, such as mechanical, adhesively, or some other desired method of attachment. A single hinge bracket 304 can run the entire length of the long edge of the frame member 302, or alternatively, a plurality of individual brackets 304 can be affixed to the long edge of the frame member 302, similar to hinges of a door. It should be noted that the hinge bracket(s) 304 do not need to be affixed to both long edges of the frame member 302. For example, if the PV module 200 is the end solar cell panel of the panel system 300, then only one long edge of frame member 302 of the PV module 200 that is proximate an adjacent PV module 200 requires the hinge bracket(s) 304. Otherwise, both long edges of the PV module 200 require the hinge bracket(s) 304. It will be appreciated that the hinge bracket(s) 304 can be integrally formed with the frame member 302, rather than affixed to the frame member 302.

The hinge bracket(s) 304 may include one or more perforations 305 to permit run-off of precipitation, such as rain water, snow melt, and the like, on the PV module 200. The perforations 305 also allow airflow through the PV module 200 to reduce lift of the PV module 200. In addition, the PV module 200 can include perforations (not shown) between the slivers 14 to allow airflow through the PV module 200 and to further reduce lift. It will be appreciated that other suitable means known in the art can be included in the solar panel system 300 of the invention to further reduce lift, such as gull wings, airfoils, and the like.

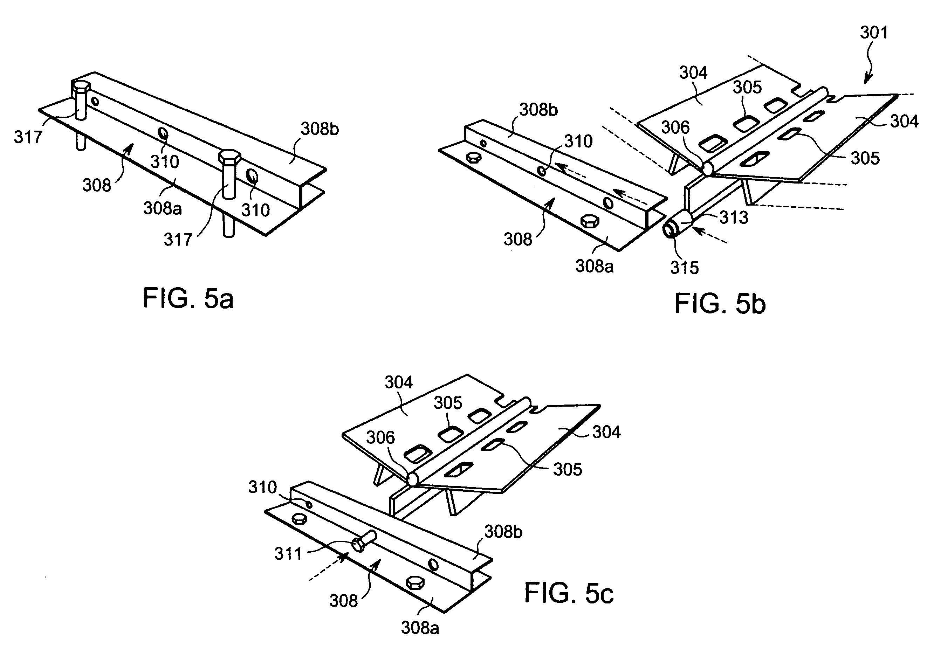

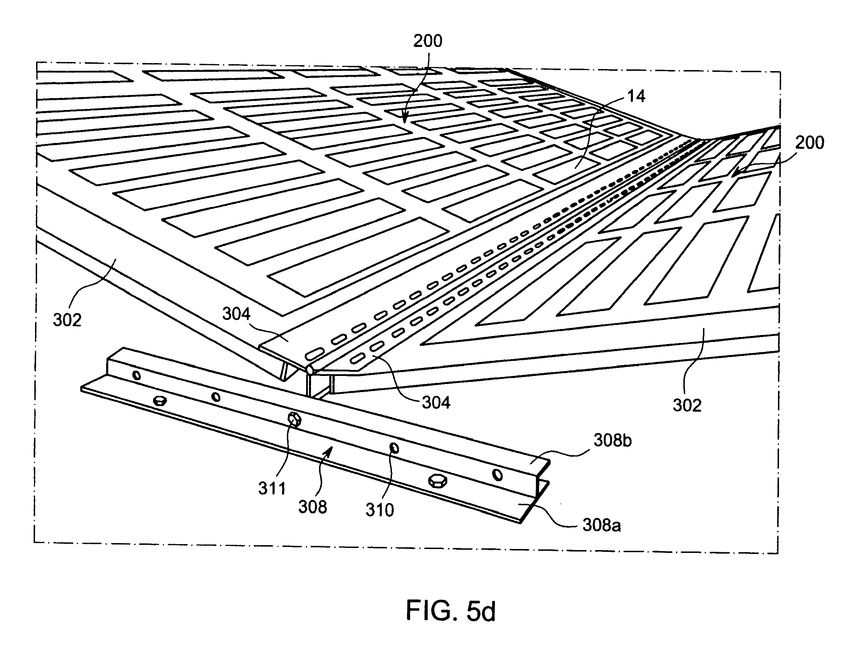

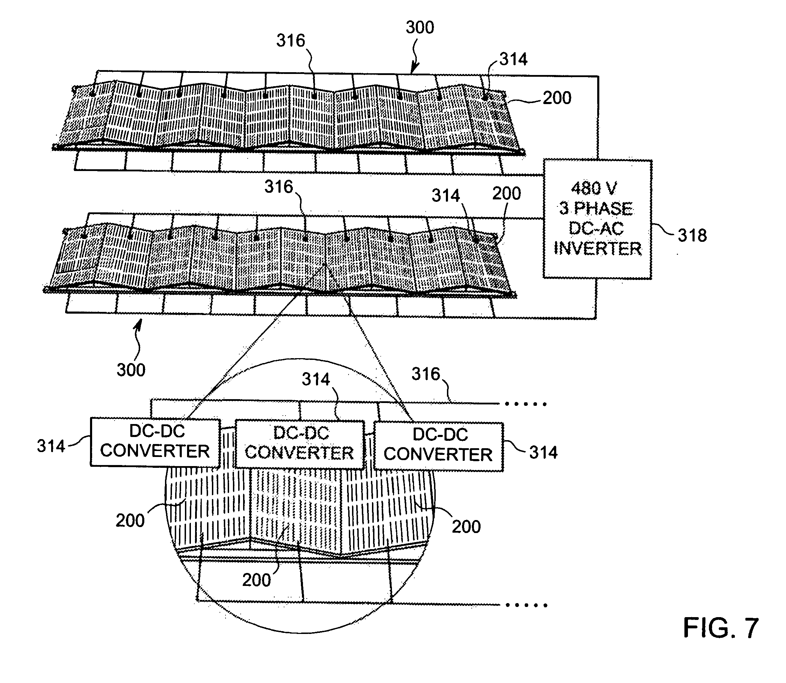

In the illustrated embodiment, the hinge bracket 304 is a female hinge bracket and a hinge pin 306 is inserted into the female hinge bracket 304, as shown in FIG. 5. The hinge pin 306 is inserted into two adjacent female hinge brackets 304 to hingedly connect two adjacent PV modules 200 to each other and allows the two adjacent PV modules 200 to pivot with respect to each other about the hinge pin 306 to any desirable angle between about 0 degrees and about 360 degrees. In this manner, the PV modules 200 can be folded on top of each other into a stacked arrangement in a packaging container 326 for ease of shipment, as shown in FIG. 7.

It will be appreciated that the invention is not limited by the hinge assembly 301 comprising the hinge bracket/hinge pin arrangement and that alternative hinge assemblies can be used to mechanically couple each PV module 200 of the solar panel system 300. For example, the hinge assembly 301 may comprise a compliant structure, such as a living hinge, and the like. The compliant structure can be made of a lightweight, elastic material, such as plastic, and the like, in which a thinned section of the plastic allows the PV modules 200 to bend in both directions. The living hinge can be integrally molded with the frame member 202 by injection molding to form a lightweight, durable hinge assembly.

Assuming each PV module 200 weighing about 0.5 lbs/ft² and having about 10 ft² of surface area, the total weight of the solar panel system 300 of the invention with a package of ten (10) PV modules 200 is about 50 lbs, which can be easily carried by the installer. By contrast, conventional PV modules weigh about 4-7 lbs/ft², and the total weight of the same number of PV modules would be about ten (10) times as much, or about 500 lbs. As can be readily seen, the solar panel system 300 of the invention is much lower in weight than a comparable number of conventional solar panels, thereby significantly reducing costs associated with shipping the solar panel system.

As shown in FIG. 4, alternating PV modules 200 can be positioned at an angle, A1, and a complementary angle, A2, such that the solar panel system 300 forms a shape similar to an accordion when deployed. For example, the angle, A2, can be between about 0 degrees and 45 degrees, and in particular between about 2 degrees and 35 degrees, and in more particular between about 5 degrees and 10 degrees. The angle, A1, would be the complementary angle between about 180 degrees and 135 degrees, and in particular between about 178 degrees and 145 degrees, and in more particular between about 175 degrees and 170 degrees, respectively. The folding and unfolding feature of the invention provides a great amount of flexibility when positioning the PV modules 200 during installation of the solar panel system 300.

The solar panel system 300 also includes one or more mounting channels 308 having a base portion 308a with a substantially planar profile and a mounting portion 308b with a substantially U-shaped profile. In the illustrated embodiment, each mounting channel 308 also includes a plurality of spaced-apart apertures 310 capable of receiving fastening members 311, 317, such as threaded fasteners, as shown in FIG. 5. A foot member 313 extending from two adjacent PV modules 200 can be inserted and moved along the mounting portion 308b until an aperture 315 in the foot member 313 is aligned with a desired aperture 310 in the mounting channel 308. Once both apertures 310, 315 are aligned, the mounting pin 311 can be inserted through the aperture 310 and into the aperture 315 of the foot member 313 to securely hold the PV module 200 in place at the desired location along the mounting channel 308. The foot member 313 should be designed to easily slide along the mounting portion 308b of the mounting channel 308. To this end, the foot member 313 can include a roller, or other suitable means to minimize friction between the foot member 313 and the mounting channel 308 when sliding along the mounting portion 308b of the mounting channel 308.

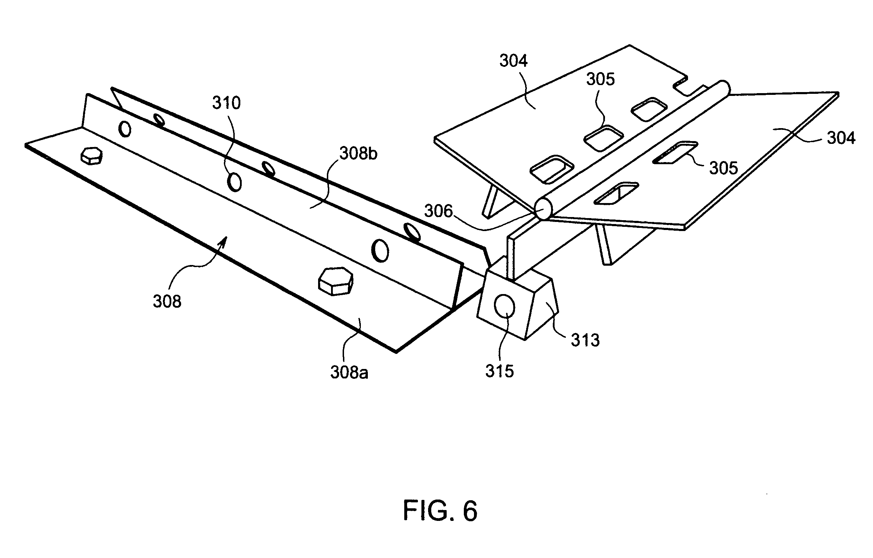

It will be appreciated that the invention is not limited by the particular design of the mounting channel 308, and that the invention can be practiced with any suitable design. As shown in FIG. 6, for example, the base portion 308a of the mounting channel 308 may be substantially planar profile, while the mounting portion 308b may be a profile shape of a truncated trapezoid, similar to a dovetail. In this embodiment, a dovetail-shaped foot member 313 can be inserted into and slid along the mounting portion 308b until an aperture 315 of the foot member 313 is aligned with a desired aperture 310 of the mounting channel 308 such that the mounting pin 311 can be inserted through the desired aperture 310 and into the aperture 315 of the foot member 313 to securely hold the PV module 200 in place at the desired location along the mounting channel 308. If necessary, the solar panel system 300 may also include a support member (not shown), for example, a rod-like member, and the like, for supporting the PV modules 200 at the desired tilt angle when installed on the roof.

As can be easily understood, a tilt angle of the PV modules 200 can be selectively adjusted by inserting the mounting pin 311 in the desired aperture 310 of the mounting channel 308. The number of apertures 310 in the mounting portion 308b can be varied, depending on the desired degree of selective adjustment of the tilt angle of the PV modules 200. A larger number of apertures 310 in the mounting portion 308b provide a greater degree of selective adjustment of the tilt angle of the PV modules 200, and vice versa. For example, the apertures 310 can be pre-drilled in the mounting portion 308b of the mounting channel 308 with a distance in the range about one-quarter inch to about 2-inches apart from each other. In the illustrated embodiment, a pair of mounting channels 308 are positioned at a distance approximately equal to the width, W, of the PV modules 200 such that the mounting pin 311 of the PV module 200 can be inserted through a desired aperture 310 in both mounting channels 308 during the installation of the solar panel system 300.

As mentioned earlier, each PV module 200 of the solar panel system 300 is electrically coupled to each other prior to shipment to the installation site. Because the PV modules 200 are already electrically coupled to each other prior to shipment, installation costs are reduced as compared to conventional solar panel systems that need to be connected to each other at the installation site. There are many ways to electrically couple each PV module 200 of the solar panel system 300.

Referring now to FIG. 7, one way to electrically couple each PV module 200 of the solar panel system 300 is to provide each PV module 200 with a DC-DC converter 314 and connect each DC-DC converter 314 in a series string 316. The series string 316 from each solar panel system 300 can be electrically coupled to a 3-phase DC-AC inverter 318 having a medium-high voltage, such as a 480 V 3-phase DC-AC converter, at the installation site.

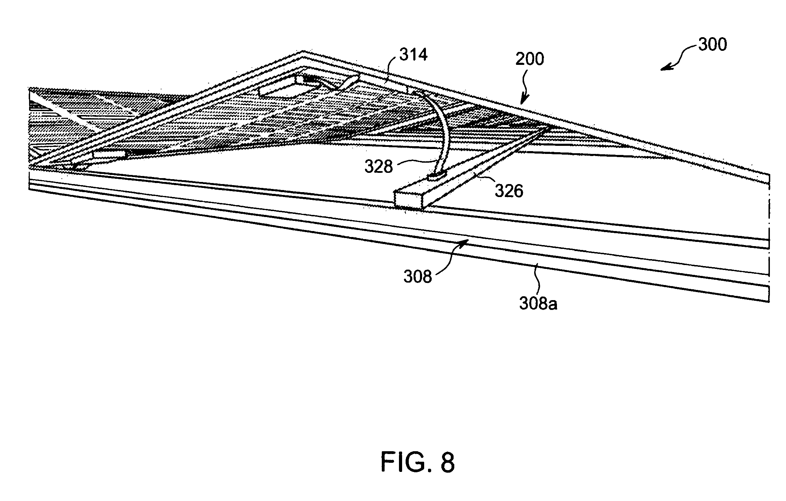

Another way to electrically couple each PV module 200 of the solar panel system 300 is to electrically couple the series string 316 to a single DC-DC converter 314 for each solar panel system 300, as shown in FIG. 8. The DC-DC converter 314 from a desired number of solar panel systems 300 can be electrically coupled to a solar grid interconnection interface 326 (or combiner strip) by simply plugging a connection harness 328 from each DC-DC converter 314 into the interconnection interface 326. The interface 326 can be, in turn, electrically coupled to the DC-AC inverter 318 (shown in FIG. 7).

Other ways of electrically connecting each PV module 200 of the solar panel system 300 are within the scope of the invention. For example, the series string 316 can be electrically connected to a DC-DC converter and/or a DC/AC inverter separate from the solar panel system 300 to convert the voltage from the series string 316 to the appropriate type of voltage.

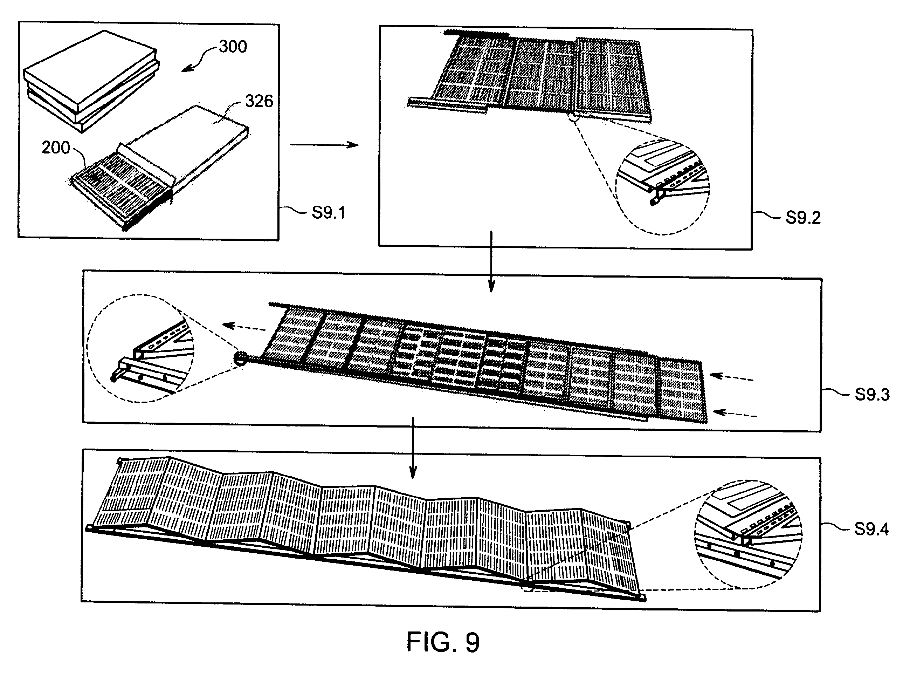

A method for deploying the solar panel system 300 of the invention on a roof 400, such as a low slope commercial roof, and the like, is shown in FIG. 9. Basically, the solar panel system 300 can be easily deployed using a simple four-step process. First, a plurality of mechanically and electrically coupled solar cell panels or PV modules 200 comprising the solar panel system 300 are folded on top of each other into a stacked arrangement for ease of shipment in a packaging container 330 in Step S9.1. For example, the solar panel system 300 may include a total of 10 electrically and mechanically coupled solar cell panels or PV modules 200 that are folded on top of each other and shipped in the packaging container 326.

Next, the mounting channels 308 are attached to the roof 400 using any known means, such as adhesive, thermal weld, and the like, to hold the mounting channel 308 in place, as shown in Step S9.2. Once the mounting channels 308 are attached, the PV modules 200 of the solar panel system 300 are unfolded and the foot member 313 extending between two adjacent PV modules 200 is inserted into the mounting channels 308. The PV modules 300 are fed through the mounting channels 308 until the aperture 315 in the foot member 313 is aligned with an appropriate aperture 310 in the mounting channel 308, where the PV module 200 is attached to the mounting channel 308 with the threaded pin 311, as shown in Step 9.3. The location in which the threaded pin 311 is inserted into the aperture 310 determines the tilt angle or declination angle of the PV module 200. Installation is complete when each of the PV modules 200 of the solar panel system 300 is attached to the mounting channels 308 at the desired location, as shown in Step S9.4.

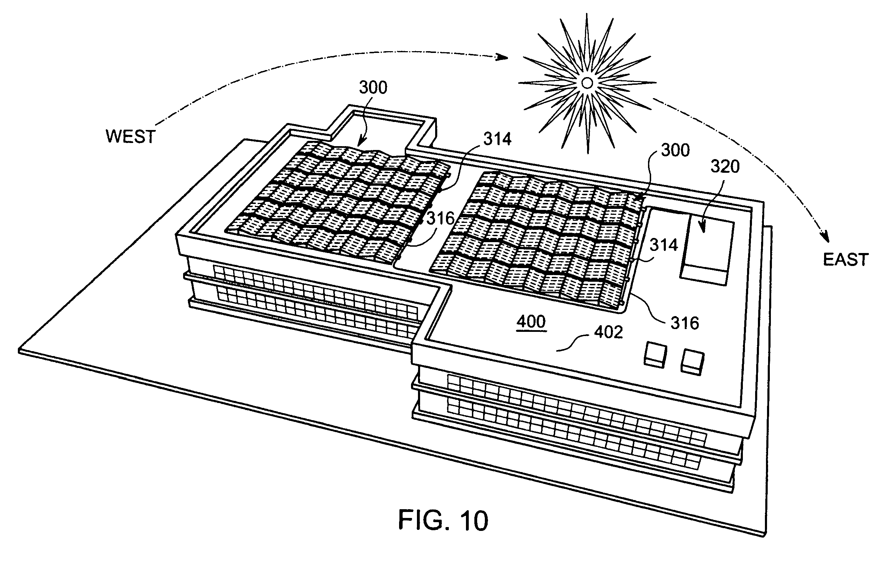

FIG. 10 shows the low slope commercial roof 400 with several solar panel systems 300 installed thereon. In operation, the roof 400 may include a reflective surface 402 that acts as a light-trapping device. Light that strikes the bi-facial sliver cells 14 are absorbed and converted into electrical energy. Light that is not absorbed by the sliver cells 14 (either passing through the cell, or transmitted through the optically clear encapsulation between the solar cells) is reflected by the surface 402 of the roof 400 towards the backside of the bi-facial sliver cells 14. This configuration can provide a higher energy over the course of a day by recapturing low angle light that is reflected (albedo). The amount of light trapping is dependent upon the angles and coatings that may be used on the PV modules 200. Ideally, over 90% of the light energy falling onto the roof would be captured.

## Claims

1. A deployable solar panel system (300) comprising a plurality of solar cell panels (200) that are mechanically and electrically coupled to each other, wherein the plurality of solar cell panels (200) are mechanically coupled to each other by a hinge assembly (301) so that the plurality of solar cell panels (200) can be folded in a stacking arrangement for shipment, and unfolded during installation; **characterised in that** the system further comprises
at least one mounting channel (308) with at least one aperture (310) for receiving a fastening member (311), and
a foot member (313) extending from between two adjacent panels of the plurality of solar cell panels (200), the foot member (313) adapted to be received within the mounting channel (308), the foot member including an aperture (315) for receiving a said fastening member (311) inserted in a selected one of the at least one aperture (310) of the mounting channel (308) for installing the plurality of solar cell panels (200) at a desired tilt angle (A1, A2).

2. The system according to Claim 1, wherein the hinge assembly (301) comprises at least one hinge bracket (304) and a hinge pin (306) inserted through the hinge bracket.

3. The system according to Claim 1 or Claim 2, wherein the plurality of solar cell panels (200) are electrically coupled to each other in a series string (316) prior to shipment to the installation site.

4. The system according to Claim 3, wherein the series string (316) is electrically coupled to one of a DC-DC converter (314) and a DC-AC inverter (318).

5. A method for installing a deployable solar cell system (300) comprising:
mechanically and electrically coupling a plurality of solar cell panels (200) to each other for shipment, wherein the plurality of solar cell panels (200) are mechanically coupled to each other by a hinge assembly (301) and include at least one foot member (313) extending from between two adjacent panels of the plurality of solar cell panels (200), the foot member (313) including an aperture (315) for receiving a fastening member (311);
folding the plurality of solar cell panels (200) in a stacking arrangement for shipment to an installation site;
**characterized in that** the method further comprises:
attaching to the installation site (400) at least one mounting channel (308) with at least one aperture (310) capable of receiving a said fastening member (311), the at least one mounting channel (308) adapted to receive the foot member (313);
unfolding the plurality of solar cell panels (200), and
inserting the at least one foot member (313) into the at least one mounting channel (308) and aligning an aperture (315) in the at least one foot member (313) with a selected aperture (310) in the at least one mounting channel (308) for installing the plurality of solar panels to a desired tilt angle (A1, A2).

6. The method according to Claim 5, wherein the plurality of solar cell panels (200) are electrically coupled to each other by a series string (316).

## Patentansprüche

1. Entfaltbares Solarpanelsystem (300), das mehrere Solarzellenpanels (20) aufweist, die mechanisch und elektrisch miteinander verbunden sind, wobei die mehreren Solarzellenpanels (200) mechanisch miteinander über eine Scharnieranordnung (301) so verbunden sind, dass die mehreren Solarzellenpanels (200) in einer Stapelanordnung für den Transport gefaltet werden können, und während des Aufbaus entfaltet werden können;
**dadurch gekennzeichnet, dass** das System ferner aufweist:
wenigstens eine Befestigungsschiene (308) mit wenigstens einer Öffnung (310) zum Aufnehmen eines Befestigungselementes (311), und
ein Fußelement (313), das sich aus Zwischenraum von zwei benachbarten Panels der mehreren Solarzellenpanels (200) erstreckt, wobei das Fußelement (313) zur Aufnahme in der Befestigungsschiene (308) angepasst ist, das Fußelement eine Öffnung (315) zum Aufnehmen des Befestigungselementes (311) enthält, das in eine ausgewählte von der wenigstens einen Öffnung (310) der Befestigungsschiene (308) gesteckt wird, um die mehreren Solarzellenpanels (200) in einem gewünschten Kippungswinkel (A1, A2) aufzustellen.

2. System nach Anspruch 1, wobei die Scharnieranordnung (301) wenigstens einen Scharnierträger (304) und einen durch den Scharnierträger gesteckten Scharnierstift (306) aufweist.

3. System nach Anspruch 1 oder Anspruch 2, wobei die mehreren Solarzellenpanels (200) elektrisch in einer Reihenschaltung (316) vor dem Transport an den Aufstellort miteinander verbunden werden.

4. System nach Anspruch 3, wobei die Reihenschaltung (316) elektrisch mit einem DC/DC-Wandler (314) und einem DC/AC-Umrichter (318) verbunden wird.

5. Verfahren zum Aufstellen eines entfaltbaren Solarzellensystems (300), mit den Schritten:
mechanisches und elektrisches Verbinden mehrerer Solarzellenpanels (200) miteinander für den Transport, wobei die mehreren Solarzellenpanels (200) durch eine Scharnieranordnung (301) mechanisch miteinander verbunden werden und wenigstens ein Fußelement (313) enthalten, das sich aus dem Zwischenraum zweier benachbarter Panels von den mehreren Solarzellenpanels (200) erstreckt, wobei das Fußelement (313) eine Öffnung (315) zur Aufnahme eines Befestigungselementes (311) enthält;
Falten der mehreren Solarzellenpanel (200) in einer Stapelanordnung für den Transport zu einem Aufstellort;
**dadurch gekennzeichnet, dass** das Verfahren ferner den Schritt aufweist:
Anbringen wenigstens einer Befestigungsschiene (308) an dem Aufstellort (400) mit wenigstens einer Öffnung (310), die das Befestigungselement (311) aufnehmen kann, wobei die wenigstens eine Befestigungsschiene (308) zur Aufnahme des Fußelementes (313) angepasst ist;
Entfalten der mehreren Solarzellenpanel (200), und
Einführen des wenigstens einen Fußelementes (313) in die wenigstens eine Befestigungsschiene (308) und Ausrichten einer Öffnung (315) in dem wenigstens einen Fußelement (313) zu einer ausgewählten Öffnung (310) in der wenigstens einen Befestigungsschiene (308) zum Aufstellen der mehreren Solarpanel in einem gewünschten Kippwinkel (A1, A2).

6. Verfahren nach Anspruch 5, wobei die mehreren Solarzellenpanels (200) elektrisch durch eine Reihenschaltung (316) miteinander verbunden werden.

## Revendications

1. Système de panneaux solaires déployables (300), comprenant divers panneaux de cellules solaires (200), qui sont couplés mécaniquement et électriquement entre eux, dans lequel les divers panneaux de cellules solaires (200) sont couplés mécaniquement entre eux par un ensemble à charnière (301), de sorte que la pluralité de panneaux de cellules solaires (200) peut être pliée en un agencement d'empilage pour l'expédition et déplié durant l'installation ;
**caractérisé en ce que** le système comprend, en outre,
au moins un canal de montage (308) avec au moins une ouverture (310), destinée à loger un élément de fixation (311) et
un élément de pied (313), qui s'étend entre deux panneaux adjacents de la pluralité de panneaux de cellules solaires (200), l'élément de pied (313) étant adapté pour être logé dans le canal de montage (308), l'élément de pied comportant une ouverture (315), destinée à loger un dit élément de fixation (311), inséré dans une ouverture sélectionnée de la au moins une ouverture (310) du canal de montage (308), pour installer la pluralité de panneaux de cellules solaires (200) suivant un angle souhaité d'inclinaison (A1, A2).

2. Système selon la revendication 1, dans lequel l'ensemble à charnière (301) comprend au moins une patte articulée (304) et un axe d'articulation (306), inséré dans la patte articulée.

3. Système selon la revendication 1 ou la revendication 2, dans lequel les divers panneaux de cellules solaires (200) sont couplés électriquement entre eux en une chaîne en série (316) avant l'expédition vers le site d'installation.

4. Système selon la revendication 3, dans lequel la chaîne en série (316) est couplée électriquement à un élément parmi un convertisseur CC - CC (314) et un onduleur CC - CA (318).

5. Procédé, destiné à installer un système de panneaux de cellules solaires déployables (200), comprenant les opérations, consistant à :
coupler mécaniquement et électriquement divers panneaux de cellules solaires (200) entre eux pour l'expédition, dans lequel les divers panneaux de cellules solaires (200) sont couplés mécaniquement entre eux par un ensemble à charnière (301) et comportent au moins un élément de pied (313), qui s'étend entre deux panneaux adjacents de la pluralité de panneaux de cellules solaires (200), l'élément de pied (313) comportant une ouverture (315), destinée à loger un élément de fixation (311) ;
plier la pluralité de panneaux de cellules solaires (200) en un agencement d'empilage pour l'expédition vers un site d'installation ;
**caractérisé en ce que** le procédé comprend, en outre les opérations, consistant à :
fixer sur le site d'installation (400) au moins un canal de montage (308) avec au moins une ouverture (310), apte à loger un dit élément de fixation (311), le au moins un canal de montage (308) étant adapté pour loger l'élément de pied (313) ;
déplier la pluralité de panneaux de cellules solaires (200) et
insérer le au moins un élément de pied (313) dans le au moins un canal de montage (308) et aligner une ouverture (315) dans le au moins un élément de pied (313) avec une ouverture sélectionnée (310) dans le au moins un canal de montage (308), pour installer la pluralité de panneaux solaires (200) suivant un angle souhaité d'inclinaison (A1, A2).

6. Procédé selon la revendication 5, dans lequel les divers panneaux de cellules solaires (200) sont couplés électriquement entre eux par une chaîne en série (316).
